# EUROPEAN PATENT SPECIFICATION

(11) **EP 2 884 650 B1**
(45) Date of publication and mention of the grant of the patent: **19.09.2018**
(21) Application number: 12882834.0
(22) Date of filing: 10.08.2012
(51) Int. Cl.: H02M 7/487, H01L 25/11, H05K 7/02, H05K 7/14

(54) **POWER MODULE COMPRISING TWO ELEMENTS, AND THREE-LEVEL POWER CONVERSION DEVICE USING SAME**
STROMMODUL MIT ZWEI ELEMENTEN SOWIE DREISTUFIGE STROMWANDLERVORRICHTUNG DAMIT
MODULE DE PUISSANCE COMPRENANT DEUX ÉLÉMENTS, ET DISPOSITIF DE CONVERSION DE PUISSANCE À TROIS NIVEAUX L'UTILISANT

(43) Date of publication of application: 17.06.2015
(73) Proprietor: Mitsubishi Electric Corporation, Tokyo 100-8310 (JP)
(72) Inventor: NAKASHIMA, Yukio, Chiyoda-ku, Tokyo 100-8310 (JP)
(74) Representative: Zech, Stefan Markus
(86) International application number: PCT/JP2012/070561
(87) International publication number: WO 2014/024320

(56) References cited:
- EP-A1- 1 443 648
- EP-A1- 2 323 249
- EP-A1- 2 456 059
- JP-A- 2003 179 203
- JP-A- 2005 176 538
- JP-A- 2009 017 642
- JP-A- 2012 039 866

## Description

### Field

The present invention relates to a dual-element power module and a three-level power converter using the dual-element power module.

### Background

In a conventional railway-vehicle three-level power converter using a dual-element power module, among four switching elements that are connected in series to constitute upper and lower arms, outer switching elements (a switching element positioned on the higher potential side, and a switching element positioned on the lower potential side) are configured by a dual-element power module, and inner switching elements (two switching elements interposed between the two outer switching elements) are configured by a dual-element power module. Clamp diodes that are connected between a connection point between two switching elements that constitute the upper arm and a connection point between two switching elements that constitute the lower arm are configured by using separate diode modules (Patent Literature 1 mentioned below, for example).

Document EP2323249 A1 discloses another three-level power converter comprising dual-element power modules.

Document EP1443648 A1 discloses, in figure 3, a three-level power converter comprising dual-element power modules, wherein the power modules have a different arrangement of external electrodes than in the present invention.

### Citation List

### Patent Literature

Patent Literature 1: International Publication No. WO2008/075418

### Summary

### Technical Problem

As described above, in the conventional railway-vehicle three-level power converter using a dual-element power module, the outer switching elements are configured by the dual-element power module, and the inner switching elements are configured by the dual-element power module. This results in a problem that the low-inductance structure within the module does not sufficiently contribute to functioning as a low-inductance circuit required for the railway-vehicle three-level power converter, and therefore the railway-vehicle three-level power converter cannot sufficiently take advantage of the features of the dual-element power module.

Patent Literature 1 mentioned above refers to an arrangement of the elements and positions of terminals in a dual-element power module. However, there is still room for improvement in the contribution of the arrangement of each module to achieving a low-inductance circuit required for the railway-vehicle three-level power converter. Therefore, a lower-inductance structure has been desired.

The present invention has been achieved to solve the above problems, and an object of the present invention is to provide a three-level power converter that can sufficiently take advantage of the features of a dual-element power module, and that can configure a lower-inductance circuit.

### Solution to Problem

To solve the above described problems and achieve the object according to the present invention a three-level power converter accordig to claim 1.

### Advantageous Effects of Invention

According to the present invention, a low-inductance circuit can be configured with three dual-element power modules having the same configuration.

### Brief Description of Drawings

FIG. 1 is a perspective view showing a schematic shape of a dual-element power module.
FIG. 2 is a circuit diagram of the dual-element power module shown in FIG. 1.
FIG. 3 is a partial circuit diagram for explaining a circuit configuration of a three-level power converter.
FIG. 4 is a partial circuit diagram of a three-level power converter to which an inductance loop is added.
FIG. 5 is a partial circuit diagram of a three-level power converter according to the first embodiment.
FIG. 6 is a circuit diagram according to the invention as claimed, which is obtained by rewriting the circuit diagram in FIG. 5 such that switching elements in each group are adjacent to each other.
FIG. 7 is a circuit diagram in which two inductance loops are added to the circuit diagram in FIG. 6.
FIG. 8 is an explanatory diagram of an operation of the three-level power converter according to the invention as claimed.
FIGS. 9 are explanatory diagrams of an effect of configuring a dual-element power module with three terminals.
FIG. 10 is a top view schematically showing an example of a module arrangement in a three-level power converter using a dual-element power module according to a first embodiment of the present invention.
FIG. 11 is a top view schematically showing an example of a module arrangement in a three-level power converter using a dual-element power module according to a second embodiment of the present invention.
FIG. 12 is a cross-sectional view when viewed from the X direction of an arrow in FIG. 11.
FIG. 13 is a cross-sectional view when viewed from the Y direction of an arrow in FIG. 11.

### Description of Embodiments

Exemplary embodiments of a three-level power converter will be explained below in detail with reference to the accompanying drawings.

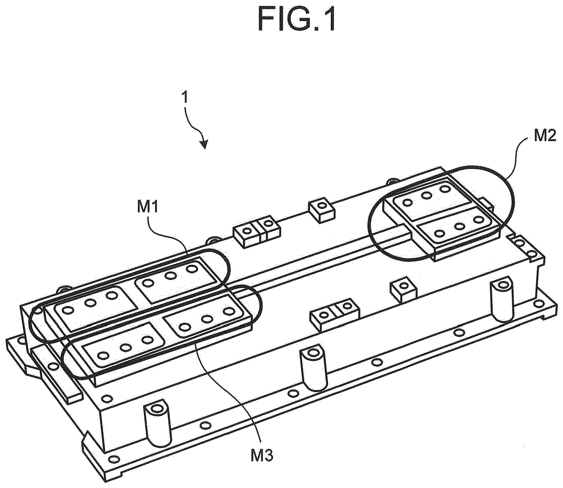

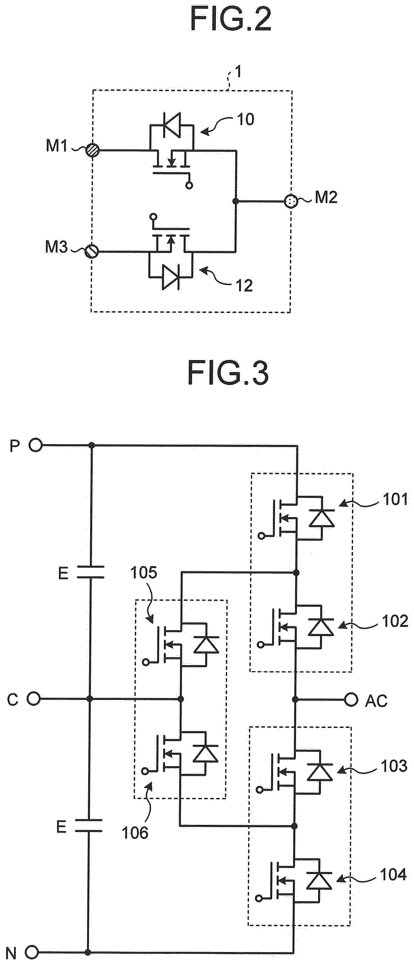

First, a dual-element power module according to be applied to the present invention is explained with reference to FIGS. 1 and 2. FIG. 1 is a perspective view showing a schematic shape of the dual-element power module according to the first embodiment. FIG. 2 is a circuit diagram of the dual-element power module shown in FIG. 1.

As shown in FIGS. 1 and 2, a dual-element power module 1 according to the first embodiment has two pairs of elements that are a first element pair 10 and a second element pair 12 accommodated in a package (module casing). In each of the two pairs of elements, a MOSFET that serves as a switching element, and a diode that operates as a so-called flywheel diode (hereinafter, "FWD") are connected in inverse parallel.

The first element pair 10 includes a first electrode M1 that is electrically connected to a connection portion (higher-side potential portion) where a drain of the MOSFET and a cathode of the FWD are electrically connected within the module, and a second electrode M2 that is electrically connected to a connection portion (lower-side potential portion) where a source of the MOSFET and an anode of the FWD are electrically connected within the module. In the second element pair 12, a drain of the MOSFET and a cathode of the FWD are electrically connected within the module, and this connection portion (higher-side potential portion) is electrically connected to the second electrode M2. The first element pair 10 also includes a third electrode M3 that is electrically connected to a connection portion (lower-side potential portion) where a source of the MOSFET and an anode of the FWD are electrically connected within the module. Also in the case of using a switching element other than the MOSFET, the cathode side of the FWD in a first element pair and a second element pair is referred to as "higher side" or "higher potential side", and the anode side of the FWD in the first element pair and the second element pair is referred to as "lower side" or "lower potential side".

The first to third electrodes are provided on one of the main-surface sides of the module casing. The first electrode and the third electrode are arrayed in a direction orthogonal to a longitudinal direction of the module casing on one of the end sides in the longitudinal direction, whereas the second electrode is arranged on the other end side in the longitudinal direction of the module casing.

In the manner as described above, the dual-element power module according to the first embodiment is configured as a triple-terminal module that includes three electrodes (terminals) that are the first electrode M1 to the third electrode M3 led out on the same main-surface side. A gate electrode (a terminal) is provided separately from the three electrodes.

Next, a three-level power converter using the power module according to the first embodiment is explained.

First, FIG. 3 is a partial circuit diagram for explaining the circuit configuration of the three-level power converter. FIG. 3 shows the configuration of a DC link unit and a power-conversion circuit unit for one phase in the three-level power converter that is preferably used for a railway vehicle. In the DC link unit, there are two capacitors that are connected in series, a higher-side DC terminal P that is connected to one end of the two capacitors, a lower-side DC terminal N that is connected to the other end, and an intermediate-potential terminal C that is connected to a point where the two capacitors are connected. The side where there is the higher-side DC terminal P is referred to as "higher potential side", and the side where there is the lower-side DC terminal N is referred to as "lower potential side". The power-conversion circuit unit for one phase selects any of the potentials of the higher-side DC terminal P, the intermediate-potential terminal C, and the lower-side DC terminal N, and outputs the selected potential to an AC terminal AC.

As shown in FIG. 3, the power-conversion circuit unit in the three-level power converter is configured by including: a switching element (hereinafter, "higher outer switching element") 101 that is positioned on the outer side of the higher potential side; a switching element (hereinafter, "higher inner switching element") 102 that is positioned on the inner side of the higher potential side; a switching element (hereinafter, "lower inner switching element") 103 that is positioned on the inner side of the lower potential side; a switching element (hereinafter, "lower outer switching element") 104 that is positioned on the outer side of the lower potential side; a switching element (hereinafter, "higher-side clamp element") 105 that operates as a neutral-point clamp diode on the higher potential side; and a switching element (hereinafter, "lower-side clamp element") 106 that operates as a neutral-point clamp diode on the lower potential side.

In the case where the power-conversion circuit unit that includes the six switching elements is configured by using the dual-element power modules, it is a general or typical concept to combine the higher outer switching element 101 and the higher inner switching element 102; combine the lower inner switching element 103 and the lower outer switching element 104; and combine the higher-side clamp element 105 and the lower-side clamp element 106, respectively, as shown in FIG. 3.

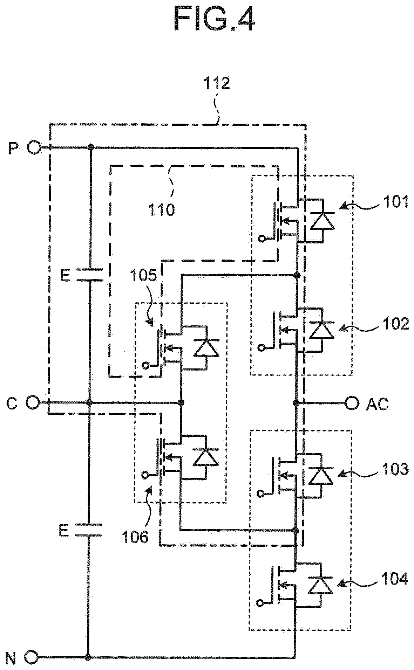

FIG. 4 is a circuit diagram in which loops (hereinafter, "inductance loops") 110 and 112 that are vulnerable to a current change rate (di/dt), that is vulnerable to an inductance, are added to the circuit diagram in FIG. 3. While FIG. 4 shows an inductance loop between the higher-side DC terminal P and the intermediate-potential terminal C, it is apparent that a similar inductance loop is also formed between the lower-side DC terminal N and the intermediate-potential terminal C.

Referring to the inductance loops 110 and 112 shown in FIG. 4, both of the inductance loops 110 and 112 are formed straddling modules. Therefore, in order for the inductance loops 110 and 112 to have a low inductance, it is necessary to reduce not only the inductance component within a module, but also the inductance component in an electrical conductor that connects between modules. Accordingly, the groupings in the dual-element power modules shown in FIG. 3 are not advantageous from the viewpoint of achieving a low inductance in the inductance loops 110 and 112.

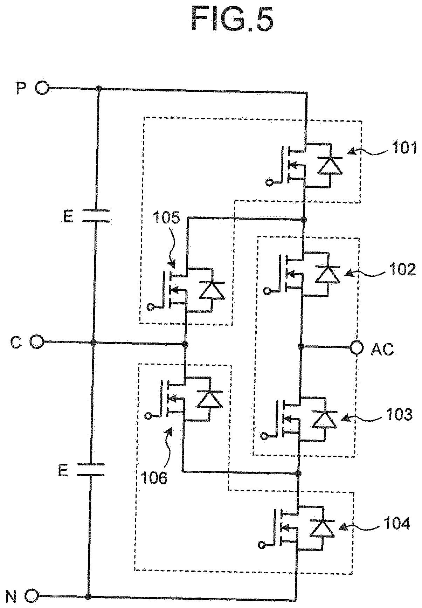

Meanwhile, FIG. 5 is a partial circuit diagram of the three-level power converter according to the first embodiment, in which the groupings are changed. Specifically, as shown in FIG. 5, the higher outer switching element 101 and the higher-side clamp element 105 are configured as a first group; the higher inner switching element 102 and the lower inner switching element 103 are configured as a second group; and the lower outer switching element 104 and the lower-side clamp element 106 are configured as a third group.

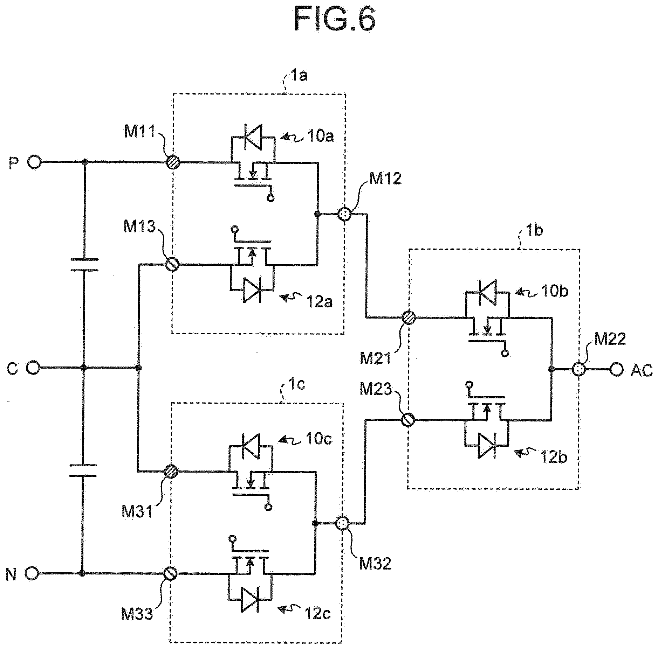

FIG. 6 is a circuit diagram in accordance with the invention as claimed, which is obtained by rewriting the circuit diagram in FIG. 5 such that switching elements in each group are in proximity from each other. Specifically, a first group of a higher outer switching element 10a (hereinafter, simply "switching element 10a" to facilitate descriptions (the same applies to other switching elements)) and a higher-side clamp element 12a (also, simply "clamp element 12a" (the same applies to other clamp elements)) is configured by a dual-element power module 1a (also, simply "module 1a" (the same applies to other dual-element power modules)). A second group with a switching element 10b and a switching element 12b is configured by a module 1b. A third group with a clamp element 10c and a switching element 12c is configured by a module 1c.

A circuit for a single arm in the three-level power converter is configured in the following manner. A first electrode M11 in the module 1a and the higher-side DC terminal P are electrically connected. A second electrode M12 in the module 1a and a first electrode M21 in the module 1b are electrically connected. A third electrode M13 in the module 1a is electrically connected to the intermediate-potential terminal C. A first electrode M31 in the module 1c is electrically connected to the intermediate-potential terminal C. A second electrode M22 in the module 1b and the AC terminal AC are electrically connected. A third electrode M23 in the module 1b and a second electrode M32 in the module 1c are electrically connected. A third electrode M33 in the module 1c and the lower-side DC terminal N are electrically connected.

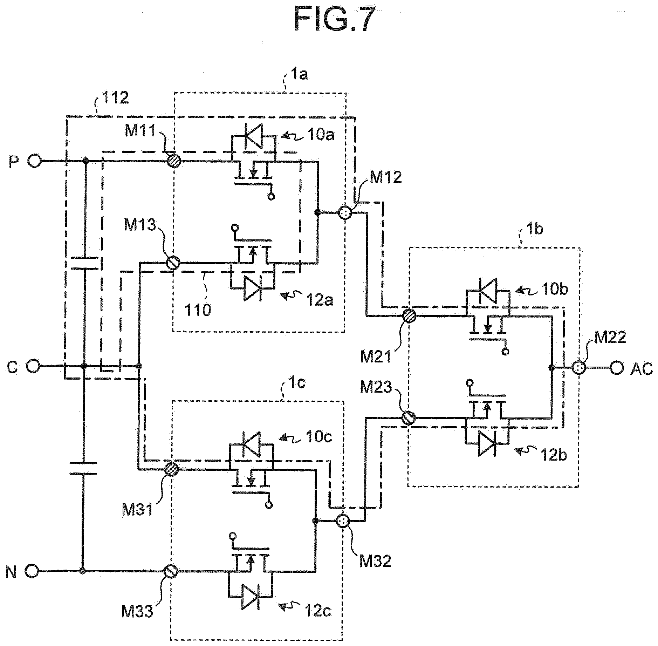

FIG. 7 is a circuit diagram in which the inductance loops 110 and 112 shown in FIG. 4 are added to the circuit diagram in FIG. 6. In the case of using the dual-element power module according to the first embodiment, as shown in FIG. 7, the path of the inductance loop 110, excluding a path extending through the DC link unit, is generated inside of the module. Therefore, assuming that the dual-element power module itself is configured to have a low inductance, the inductance loop 110 is inevitably a low-inductance circuit.

In the path of the inductance loop 112, a path extending through the DC link unit, a path connecting the first electrode M11 in the module 1a and the first electrode M21 in the module 1b, and a path connecting the third electrode M23 in the module 1b and the second electrode M32 in the module 1c, are generated outside of the modules as shown in FIG. 6. Therefore, assuming that the dual-element power module itself is configured to have a low inductance, and these three paths are configured to have a low inductance, the inductance loop 112 is inevitably a low-inductance circuit.

Inside the module 1, a current flows between the first electrode M1 and the second electrode M2, or between the second electrode M2 and the third electrode M3. Because the first electrode M1 and the third electrode M3 are arranged in proximity from each other, the distance between the current path from the first electrode M1 to the second electrode M2, and the current path from the second electrode M2 to the third electrode M3 can be reduced. Magnetic fluxes, generated by currents flowing through these current paths, cancel each other out. Therefore, the dual-element power module according to the first embodiment has a low-inductance circuit configuration.

The dual-element power module according to the first embodiment configured as described above can also be configured to be capable of reducing not only the inductance component within the module, but also the inductance component between the modules, by means of the module arrangement (a planar arrangement or a three-dimensional arrangement). This point will be described later in second and third embodiments.

Next, an operation of the three-level power converter configured by the dual-element power module according to the first embodiment is explained. Through this explanation, low-inductance characteristics specific to the dual-element power module are also explained.

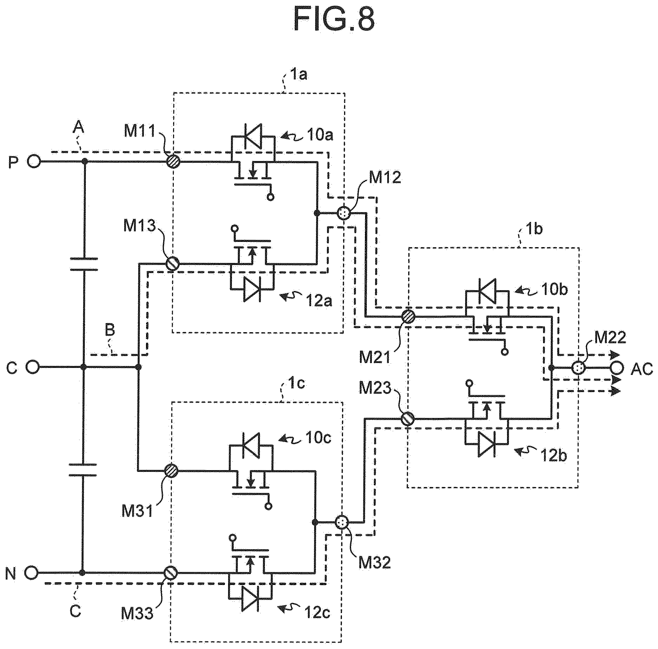

FIG. 8 is an explanatory diagram of an operation of the three-level power converter according to the invention as claimed. FIG. 8 shows the circuit diagram in FIG. 6 with current paths added. In the following explanations, there is described a case as an example, in which a current that is output from the AC terminal AC that constitutes an AC terminal of a three-level power converter is positive (rightward).

First, when the switching elements 10a and 10b are turned ON, and the switching elements 12b and 12c are turned OFF, the voltage of the higher-side DC terminal P is output to the AC terminal AC. A current flows from the higher-side DC terminal P to the AC terminal AC, or flows from the AC terminal AC to the higher-side DC terminal P, through the switching elements 10a and 10b (a current path A) .

Next, when the switching element 10a is turned OFF, and the switching element 12b is turned ON, the voltage of the intermediate-potential terminal C is output to the AC terminal AC. A current flows from the intermediate-potential terminal C through the clamp element 12a (specifically, a clamp diode) to the switching element 10b, and is then output to the AC terminal AC (a current path B). When a current flows from the AC terminal AC to the intermediate-potential terminal C, the current flows through the switching element 12b to the clamp element 10c (specifically, a clamp diode). When the switching element 10b is turned OFF, and the switching element 12b is turned ON, the voltage of the lower-side DC terminal N is output to the AC terminal AC. A current flows from the lower-side DC terminal N to the AC terminal AC, or flows from the AC terminal AC to the lower-side DC terminal N, through the switching elements 12b and 12c (a current path C).

As described above, the switching elements 10a, 10b, 12b, and 12c are brought into any of the following ON/OFF states:
State P: switching element 10a: ON, switching element 10b: ON, switching element 12b: OFF, switching element 12c: OFF;
State C: switching element 10a: OFF, switching element 10b: ON, switching element 12b: ON, switching element 12c: OFF;
State N: switching element 10a: OFF, switching element 10b: OFF, switching element 12b: ON, switching element 12c: ON.

According to changes in the ON/OFF state of switching elements, a current that flows through the switching elements changes. In view of both positive and negative currents that are a current flowing out from the AC terminal AC and a current flowing into the AC terminal AC, a current flowing through switching elements is commutated in such a manner that a current having flowed through the switching element 10a flows through the clamp element 12a. A current is commutated also between the switching element 10b and the switching element 12b. A current is commutated also between the switching element 12c and the clamp element 10c.

In the three-level power converter according to the invention as claimed, the dual-element power module is configured by a combination of these switching elements through which the commutated current flows. Therefore, in the three-level power converter according to the invention as claimed, the module arrangement thereof can contribute to achieving a low-inductance circuit required for the railway-vehicle three-level power converter.

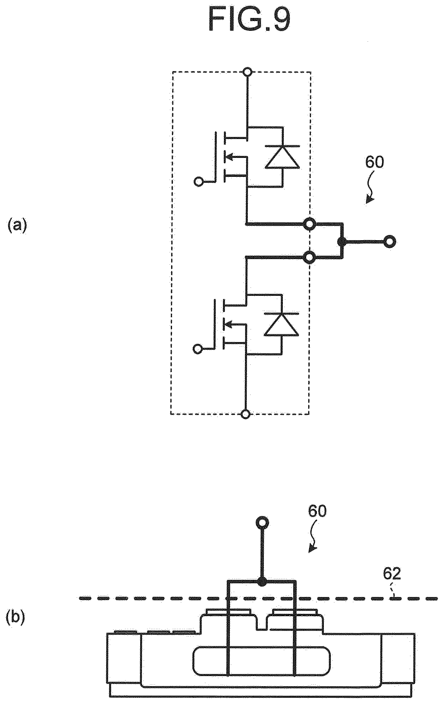

Next, the effects resulting from a dual-element power module configured by three terminals are explained. FIGS. 9 are explanatory diagrams of the effects resulting from a dual-element power module configured by three terminals.

In FIGS. 9, a dual-element power module is configured by four terminals. In the case of using the dual-element power module in a power converter such as a three-level power converter, an AC terminal unit 60 needs to be connected externally. Therefore, the AC terminal unit 60 and a PN connection conductor 62 (a DC wire for connecting a DC link unit and each switching element) vie for space with each other. In this case, as shown in FIG. 9(b) for example, when the wiring is carried out while bypassing the PN connection conductor 62, the length of a connection conductor of the AC terminal unit 60 is inevitably increased. Accordingly, an increase in inductance is inevitable. In contrast, as described in the present embodiment, in the case of a dual-element power module configured by three terminals, a lower potential electrode in one of element pairs, and a higher potential electrode in the other element pair are connected internally. Consequently, it is unnecessary to consider about wiring such as bypassing the PN connection conductor 62, and also an increase in length of the connection conductor of the AC terminal unit 60 can be suppressed. Significant effects on reducing the inductance can therefore be obtained.

As described above, the dual-element power module according to the first embodiment is configured to include first and second element pairs, in each of which a diode and a switching element are connected in inverse parallel, and to include a first electrode that is connected to a higher-side potential portion of the first element pair, a second electrode that is connected to a connection portion between a lower-side potential portion of the first element pair and a higher-side potential portion of the second element pair, and a third electrode that is connected to a lower-side potential portion of the second element pair, where the first to third electrodes in the dual-element power module are provided on one of the main-surface sides of a module casing, the first electrode and the third electrode are arrayed in a direction orthogonal to a longitudinal direction of the module casing on one of the end sides in the longitudinal direction, and the second electrode is arranged on the other end side in the longitudinal direction of the module casing. Therefore, it is possible to achieve a lower-inductance circuit as compared to a quadruple-terminal module.

The three-level power converter according to the invention as claimed includes a power-conversion circuit unit that includes a first dual-element power module that includes an outer switching element on the higher potential side and a clamp element on the higher potential side, a second dual-element power module that includes an inner switching element on the higher potential side and an inner switching element on the lower potential side, and a third dual-element power module that includes an outer switching element on the lower potential side and a clamp element on the lower potential side, where the first to third dual-element power modules are dual-element triple-terminal power modules with the same configuration, each of which includes a first electrode that is connected to a higher-side potential portion of one of elements, a second electrode that is connected to a connection portion between a lower-side potential portion of the one of the elements and a higher-side potential portion of the other element, and a third electrode that is connected to a lower-side potential portion of the other element, and where the first electrode in the first dual-element power module is connected to the higher-side DC terminal, the second electrode in the first dual-element power module and the first electrode in the second dual-element power module are connected, the third electrode in the first dual-element power module is connected to an intermediate-potential terminal, the first electrode in the third dual-element power module is connected to the intermediate-potential terminal, the second electrode in the second dual-element power module is connected to the AC terminal, the third electrode in the second dual-element power module and the second electrode in the third dual-element power module are connected, and the third electrode in the third dual-element power module is connected to the lower-side DC terminal. Therefore, it is possible to achieve a low-inductance circuit by using three dual-element power modules with the same configuration.

According to the three-level power converter of the invention as claimed, a railway-vehicle three-level power converter can be configured by using one type of power module. This is effective to reduce design costs and manufacturing costs.

### Second embodiment.

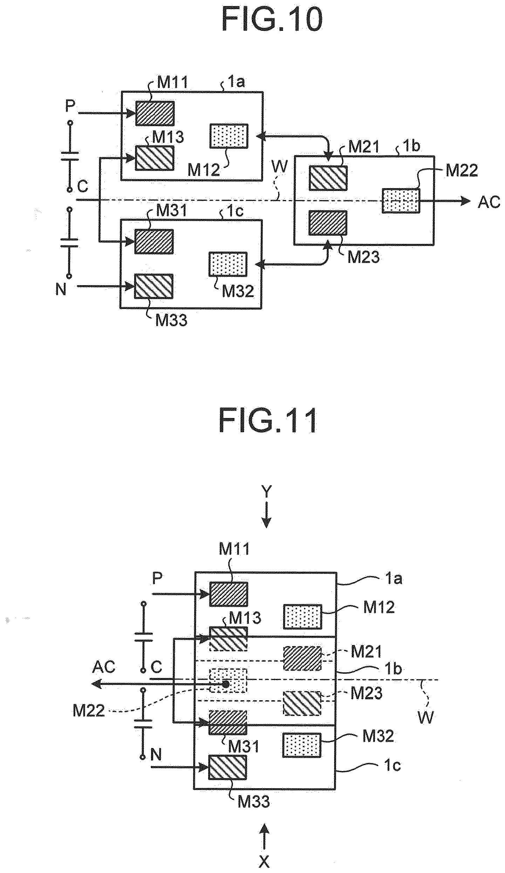

FIG. 10 is a top view schematically showing a module arrangement in a three-level power converter using a dual-element power module according to a first embodiment of the present invention. In FIG. 10, in the module arrangement according to the first
embodiment, modules 1a to 1c that constitute the three-level power converter are arranged on a plane. The modules 1a to 1c correspond to the modules 1a to 1c shown in FIG. 6, respectively.

The module 1a and the module 1c are arranged such that the longitudinal side-surfaces of their respective module casings are adjacent to each other. Electrodes in each of the modules are arranged so as to be aligned in a direction orthogonal to a center plane W between the module 1a and the module 1c shown by a dot-and-dash line. The center plane W is a plane with equal distance from the center of the module 1a and the center of the module 1c. While being shown by a line in FIG. 10, the center plane W is a plane extending in a direction vertical to the plane of the drawing sheet.

More specifically, a first electrode M11 and a third electrode M13 in the module 1a, and a first electrode M31 and a third electrode M33 in the module 1c are arranged so as to be aligned in a direction orthogonal to the center plane W.

In the case of using the same modules as the module 1a and the module 1c, and arranging them in the manner as described above, then a second electrode M12 in the module 1a and a second electrode M32 in the module 1c are inevitably aligned in a direction orthogonal to the center plane W. Therefore, a group of the second electrode M12 in the module 1a and the second electrode M32 in the module 1c may be arranged so as to be aligned in a direction orthogonal to the center plane W.

In contrast to the modules 1a and 1c arranged in the manner as described above, the module 1b is arranged in the following manner. The module 1b is parallel to the center plane W that is a plane passing through the center of the module casing, and parallel to the longitudinal direction. The second electrode M22 is positioned on the center plane W. The first electrode M21 and the third electrode M23 in the module 1b are symmetrical with respect to the center plane W. The side surface of the module casing of the module 1b, on a side where the first electrode M21 and the third electrode M23 are provided, is adjacent to the side surface of the module casing of the module 1a (the module 1c) on a side where the second electrode M12 (the second electrode M32 in the module 1c) is provided. The second electrode M22 is positioned on the center plane W, which means that any portion of the second electrode M22 is located on the center plane W.

By arranging the modules 1a to 1c in the manner as described above, an electrical wire that connects the second electrode M12 in the module 1a and the first electrode M21 in the module 1b, and an electrical wire that connects the third electrode M23 in the module 1b and the second electrode M32 in the module 1c, are wired with a very short path. Therefore, the three-level power converter with the modules 1a to 1c arranged therein can be configured by a low-inductance circuit. In FIG. 10 and other drawings, the locations of electrical wires are shown by arrowed lines.

Because modules with the same structure are used, and the second electrode M22 in the module 1b is arranged on the center plane W, an electrical wire that connects the second electrode M12 in the module 1a and the first electrode M21 in the module 1b, and an electrical wire that connects the third electrode M23 in the module 1b and the second electrode M32 in the module 1c, can have equal length, and thus a symmetrical circuit can be configured. While in FIG. 10, the outer shape of the module casing is a rectangle when viewed from the top, the outer shape of the module casing may be a trapezoid, a parallelogram, or other shapes when viewed from the top.

### Third embodiment.

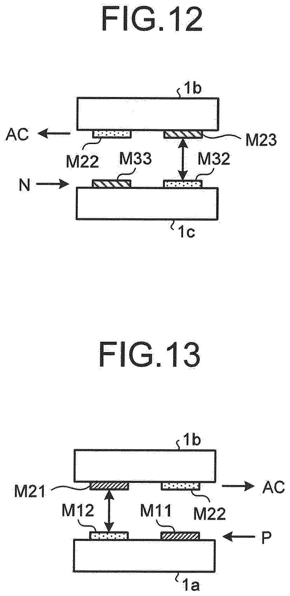

FIG. 11 is a top view schematically showing an example of a module arrangement in a three-level power converter using a dual-element power module according to a second embodiment of the present invention. FIG. 12 is a cross-sectional view when viewed from the X direction of an arrow in FIG. 11. FIG. 13 is a cross-sectional view when viewed from the Y direction of an arrow in FIG. 11.

When the arrangement example in FIGS. 11 to 13 according to the second embodiment is compared with the arrangement example in FIG. 10 according to the first embodiment, the module 1b is arranged differently. In the first embodiment, the module 1b is arranged on the same plane as the modules 1a and 1c. However, in the second embodiment, the electrode mounting surface of the module 1b is arranged so as to face (be opposed to) the electrode mounting surfaces of the modules 1a and 1c.

In addition to the above point, when the electrode mounting surfaces of the modules 1a and 1c are viewed from the back side of the electrode mounting surface of the module 1b in perspective plan view, the first electrode M11 and the third electrode M13 in the module 1a, the first electrode M31 and the third electrode M33 in the module 1c, and the second electrode M22 in the module 1b are aligned in a direction orthogonal to the center plane W between the module 1a and the module 1c, and the second electrode M22 in the module 1b is arranged so as to be positioned on the center plane W.

In the case of using the same modules as the first to third modules 1a to 1c, and arranging them in the manner as described above, when the electrode mounting surfaces of the modules 1a and 1c are viewed from the back side of the electrode mounting surface of the module 1b in perspective plan view, the second electrode M12 in the module 1a, the second electrode M32 in the module 1c, and the first electrode M21 and the third electrode M23 in the module 1b are aligned in a direction orthogonal to the center plane W between the module 1a and the module 1c.

By arranging the modules 1a to 1c in the manner as described above, an electrical wire that connects the second electrode M12 in the module 1a and the first electrode M21 in the module 1b, and an electrical wire that connects the third electrode M23 in the module 1b and the second electrode M32 in the module 1c, are wired with a very short path. Therefore, the three-level power converter with the modules 1a to 1c arranged therein can be configured by a low-inductance circuit.

Further, by arranging the modules 1a to 1c in the manner as described above, an electric wire that connects the second electrode M12 in the module 1a and the first electrode M21 in the module 1b, and an electric wire that connects the third electrode M23 in the module 1b and the second electrode M32 in the module 1c, can have equal length, and thus a symmetrical circuit can be configured.

The configuration of the dual-element power module shown in the first and second embodiments described above is merely an example, and various changes are possible. For example, while FIG. 11 illustrates the case where the module 1b is arranged above the modules 1a and 1c, the module 1b may be arranged below the modules 1a and 1c. These modules may be arranged with a horizontal relationship in place of a vertical relationship. FIG. 1 and other drawings illustrate an example of the configuration in which the first electrode M1 to the third electrode M3 are arranged in a clockwise direction on the electrode surface. However, the first electrode M1 to the third electrode M3 may be arranged in a counterclockwise direction on the electrode surface.

### Third embodiment.

The maximum available ratings of a large-capacity power module to be used for a railway-vehicle power converter are 3300V/1500A, 4500V/1200A, and 6500V/750A, for example. Such a power module has a base size of 140 mm × 190 mm due to the constraints such as bolt mounting and the control of flatness of a cooling surface. At present, these power modules are all configured as a single-element power module. As described above, a largest-capacity power device has a single element incorporated therein due to the mechanical constraints. Therefore, in order to easily realize the three-level power converter according to the first and second embodiments, it is desirable to use an intermediate-capacity power module.

Accordingly, in a third embodiment, as a semiconductor material to realize the dual-element power module according to the first and second embodiments, a wide bandgap semiconductor is used, such as SiC, GaN, or diamond. Using the wide bandgap semiconductor can reduce generated loss, and makes it possible to downsize the power module as compared to a power module with the same current rating and using a narrow bandgap semiconductor such as Si. That is, assuming that a wide bandgap semiconductor is used as a semiconductor material to realize the dual-element power module according to the first and second embodiments, in the case of configuring a large-capacity railway-vehicle power converter for example, the control of flatness of a cooler is facilitated, and therefore workability is improved.

The configurations described in the first to third embodiments are exemplary configurations of the present invention, and it is needless to mention that these configurations can be combined with other publicly known techniques and various modifications can be made without departing from the scope of the present invention.

### Industrial Applicability

As described above, the present invention is useful as a dual-element power module capable of configuring a low-inductance circuit and a three-level power converter using the dual-element power module. Reference Signs List

1, 1a, 1b, 1c dual-element power module, 10 first element pair, 12 second element pair, 10a, 101 higher outer switching element, 10b, 102 higher inner switching element, 12b, 103 lower inner switching element, 12c, 104 lower outer switching element, 12a, 105 higher-side clamp element, 10c, 106 lower-side clamp element, 60 AC terminal unit, 62 connection conductor, 110, 112 inductance loop, AC AC terminal, P higher-side DC terminal, C intermediate-potential terminal, N lower-side DC terminal, M1 first electrode, M2 second electrode, M3 third electrode, M11 first electrode (module la), M12 second electrode (module 1a), M13 third electrode (module la), M21 first electrode (module 1b), M22 second electrode (module 1b), M23 third electrode (module 1b), M31 first electrode (module c), M32 second electrode (module 1c), M33 third electrode (module 1c), W center plane.

## Claims

1. A three-level power converter comprising a power-conversion circuit unit for one phase that is arranged to select any of potentials of a higher-side DC terminal (P), an intermediate-potential terminal (C), and a lower-side DC terminal (N), and to output the selected potential to an AC terminal (AC), where the power-conversion circuit unit includes a first dual-element power module (1a) that includes an outer switching element (10a) on the higher potential side of the three-level power converter and a clamp element (12a) on the higher potential side of the three-level power converter, a second dual-element power module (1b) that includes an inner switching element (10b) on the higher potential side of the three-level power converter and an inner switching element (12b) on the lower potential side of the three-level power converter, and a third dual-element power module (1c) that includes an outer switching element (12c) on the lower potential side of the three-level power converter and a clamp element (10c) on the lower potential side of the three-level power converter, wherein the first to third dual-element power modules (1a, 1b, 1c) are dual-element triple-terminal power modules with the same configuration, each of which includes a first electrode (M11, M21, M31) that is connected to a higher-side potential portion of one of the switching elements (10a, 10b, 10c), a second electrode (M12, M22, M32) that is connected to a connection portion between a lower-side potential portion of the one of the switching elements (10a, 10b, 10c) and a higher-side potential portion of the other switching element (12a, 12b, 12c), and a third electrode (M13, M23, M33) that is connected to a lower-side potential portion of the other element (12a, 12b, 12c), and
the first electrode (M11) in the first dual-element power module (1a) is connected to the higher-side DC terminal (P), the second electrode (M12) in the first dual-element power module (1a) and the first electrode (M21) in the second dual-element power module (1b) are connected to each other, the third electrode (M13) in the first dual-element power module (1a) is connected to the intermediate-potential terminal (C), the first electrode (M31) in the third dual-element power module (1c) is connected to the intermediate-potential terminal (C), the second electrode (M22) in the second dual-element power module (1b) is connected to the AC terminal (AC), the third electrode (M23) in the second dual-element power module (1b) and the second electrode (M32) in the third dual-element power module (1c) are connected to each other, and the third electrode (M33) in the third dual-element power module (1c) is connected to the lower-side DC terminal (N); wherein the first to third electrodes (M11, M12, M13, M21, M22, M23, M31, M32, M33) in the first to third dual-element power modules (1a, 1b, 1c) are provided on an electrode mounting surface at one of main-surface sides of a module casing, and
the first electrode (M11, M21, M31) and the third electrode (M13, M23, M33) are arrayed in a direction orthogonal to a longitudinal direction of the module casing on one of the end sides in the longitudinal direction, and the second electrode (M12, M22, M32) is arranged on the other end side in the longitudinal direction of the module casing, wherein
the first and third dual-element power modules (1a, 1c) are arranged on a plane such that longitudinal side-surfaces of their respective module casings are adjacent to each other, and electrode mounting surfaces of the module casings are directed in the same direction, and the second dual-element power module (1b) is arranged such that a center line of a module casing in a longitudinal direction extends parallel to a center plane (W), the center plane (W) being orthogonal to said plane and crossing said plane between the centers of the first dual-element power module (1a) and the third dual-element power module (1c), and
wherein the second dual-element power module (1b) is arranged such that the second electrode (M22) is positioned on the crossing of said plane with the center plane, and wherein the second dual-element power module (1b), the first electrode (M21) and the third electrode (M23) are arranged symmetrically with respect to the center plane (W).

2. The three-level power converter according to claim 1, wherein the second electrode (M12) in the first dual-element power module (1a), and the second electrode (M32) in the third dual-element power module (1c) are arranged so as to be aligned in a direction orthogonal to the center plane (W).

3. The three-level power converter according to any one of claims 1 and 2, wherein the second dual-element power module (1b) is arranged such that a side surface of a module casing of the second dual-element power module (1b), on a side where the first and third electrodes (M21, M23) are provided, is adjacent to side surfaces of module casings of the first and third duel-element power modules (1a, 1c) on a side where the second electrode (M12, M32) is provided.

4. The three-level power converter according to any one of claims 1 and 2, wherein an electrode mounting surface of the second dual-element power module (1b) is arranged so as to be opposed to electrode mounting surfaces of the first and third dual-element power modules (1a, 1c), and when the electrode mounting surfaces of the first and third duel-element power modules (1a, 1c) are viewed from a back side of the electrode mounting surface of the second duel-element power module (1b) in perspective plan view, a first electrode (M11) and a third electrode (M13) in the first duel-element power module (1a), a first electrode (M31) and a third electrode (M33) in the third duel-element power module (1c), and a second electrode (M22) in the second duel-element power module (1b) are aligned in a direction orthogonal to the center plane, and a second electrode (M12) in the first duel-element power module (1a), a second electrode (M32) in the third duel-element power module (1c), and a first electrode (M21) and a third electrode (M23) in the second duel-element power module (1b) are aligned in a direction orthogonal to the center plane (W).

5. The three-level power converter according to any one of claims 1 to 4, wherein elements that constitute the first to third dual-element power modules (1a, 1b, 1c) are formed of a wide bandgap semiconductor.

6. The three-level power converter according to claim 5, wherein the wide bandgap semiconductor is a semiconductor made of silicon carbide, a gallium nitride-based material, or diamond.

## Patentansprüche

1. Dreiphasen-Leistungswandler umfassend eine Leistungswandler-Schaltungseinheit für eine Phase, die eine der Seiten des Gleichstromanschlusses (P) mit höherem Potential auswählt,
ein Zwischenpotentialanschluss (C), und einen Gleichstromanschluss (N) an der Seite mit niedrigerem Potential, und die das ausgewählte Potential an einen Wechselstromanschluss (AC) abgibt, wobei die Leistungsumwandlungs-Schaltungseinheit ein erstes Dual-Element-Leistungsmodul (1a) umfasst, das ein äußeres Schaltelement (10a) auf einer Seite des Dreiphasen-Leistungswandlers mit höherem Potential enthält
und ein Klemmelement (12a) auf der Seite des Dreiphasen-Leistungswandlers mit höherem Potential umfasst,
ein zweites Dual-Element-Leistungsmodul (1b), das ein inneres Schaltelement (10b) auf der höheren Potentialseite des Dreiphasen-Leistungswandlers enthält und ein inneres Schaltelement (12b) auf einer Seite des Dreiphasen-Leistungswandlers mit niedrigem Potential enthält,
und ein drittes Dual-Element-Leistungsmodul (1c), das ein äußeres Schaltelement (12c) auf der Seite des Dreiphasen-Leistungswandlers mit niedrigem Potential enthält
und ein Klemmelement (10c) auf der Seite des Dreiphasen-Leistungswandlers mit niedrigem Potential enthält.
wobei die ersten bis dritten Dual-Element-Leistungsmodule (1a, 1b, 1c) Dualelement-Dreifachanschluss-Leistungsmodule, mit derselben Konfiguration sind, von denen jede eine erste Elektrode (M11, M21, M31) aufweist, die mit einem Abschnittmit höherem Potential eines der Schaltelemente (10a, 10b, 10c) verbunden ist, eine zweite Elektrode (M12, M22, M32), die mit einem Verbindungsabschnitt zwischen einem unteren Potentialabschnitt des einen Schaltelements (10a, 10b, 10c) und einem oberen Potentialabschnitt des anderen Schaltelements (12a, 12b, 12c) verbunden ist, und eine dritte Elektrode (M13, M23, M33), die mit einem unteren Potentialabschnitt des anderen Elements (12a, 12b, 12c) verbunden ist, und
die erste Elektrode (M11) im ersten Dual-Element-Leistungsmodul (1a) ist mit einer Seite des Gleichstromanschlusses (P) mit höherem Potential verbunden, die zweite Elektrode (M12) im ersten Dual-Element Leistungsmodul (1a) und die erste Elektrode (M21) im zweiten Dual-Element Leistungsmodul (1b) miteinander verbunden sind,
die dritte Elektrode (M13) im ersten Dual-Element-Leistungsmodul (1a) mit dem Zwischenpotentialanschluss (C) verbunden ist, die erste Elektrode (M31) im dritten Dual-Element-Leistungsmodul (1c) mit dem Zwischenpotentialanschluss (C) verbunden ist, die zweite Elektrode (M22) im zweiten Dual-Element-Leistungsmodul (1b) mit dem Wechselstromanschluss (AC) verbunden ist, die dritte Elektrode (M23) im zweiten Dual-Element-Leistungsmodul (1b) und die zweite Elektrode (M32) im dritten Dual-Element-Leistungsmodul (1c) miteinander verbunden sind, und die dritte Elektrode (M33) im dritten Dual-Element-Leistungsmodul (1c) mit der Seite des Gleichstromanschluss (N) mit niedrigem Potential verbunden ist;
wobei
die ersten bis dritten Elektroden (M11, M12, M13, M21, M22, M23, M31, M32, M33) in den ersten bis dritten Dual-Element-Leistungsmodulen (1a, 1b, 1c) auf einer Elektrodenbefestigungsfläche an einer der Hauptflächenseiten eines Modulgehäuses vorgesehen sind, und
die erste Elektrode (M11, M21, M31) und die dritte Elektrode (M13, M23, M33) in einer Richtung orthogonal zu einer Längsrichtung des Modulgehäuses an einer der Stirnseiten in Längsrichtung angeordnet sind, und die zweite Elektrode (M12, M22, M32) auf der anderen Seite in Längsrichtung des Modulgehäuses angeordnet ist, wobei
das erste und das dritte Dual-Element-Leistungsmodul (1a, 1c) auf einer Ebene so angeordnet sind, dass die Längsseitenflächen ihrer jeweiligen Modulgehäuse nebeneinander liegen, und Elektrodenbefestigungsflächen der Modulgehäuse in einer gleichen Richtung ausgerichtet sind, und das zweite Dual-Element-Leistungsmodul (1b) so angeordnet ist, dass sich eine Mittellinie eines Modulgehäuses in Längsrichtung parallel zu einer Mittenebene (W) erstreckt, wobei die Mittenebene (W) orthogonal zu der Ebene ist und die Ebene zwischen den Mittelpunkten von dem ersten Dual-Element-Leistungsmodul (1a) und dem dritten Dual-Element-Leistungsmodul (1c) kreuzt, und
wobei das zweite Dual-Element-Leistungsmodul (1b) so angeordnet ist, dass die zweite Elektrode (M22) in der Mittelebene liegt, und
wobei das zweite Dual-Element-Leistungsmodul (1b), die erste Elektrode (M21) und die dritte Elektrode (M23) symmetrisch zur Mittelebene (W) angeordnet sind.

2. Dreiphasen-Leistungswandler nach Anspruch 1, wobei die zweite Elektrode (M12) im ersten Dual-Element-Leistungsmodul (1a) und die zweite Elektrode (M32) im dritten Dual-Element-Leistungsmodul (1c) orthogonal zur Mittelebene (W) ausgerichtet sind.

3. Dreiphasen-Leistungswandler nach einem der Ansprüche 1 und 2, wobei das zweite Dual-Element-Leistungsmodul (1b) so angeordnet ist, dass eine Seitenfläche eines Modulgehäuses des zweiten Dual-Element-Leistungsmoduls (1b), auf einer Seite, auf der die erste und dritte Elektrode (M21, M23) vorgesehen sind, an die Seitenflächen der Modulgehäuse der ersten und dritten Dual-Element-Leistungsmodule (1a, 1c) auf einer Seite angrenzt, auf der die zweite Elektrode (M12, M32) vorgesehen ist.

4. Dreiphasen-Leistungswandler nach einem der Ansprüche 1 und 2, wobei eine Elektrodenbefestigungsfläche des zweiten Dual-Element-Leistungsmoduls (1b) so angeordnet ist, dass sie den Elektrodenbefestigungsflächen des ersten und dritten Doppelelementleistungsmoduls (1a, 1c) gegenüberliegt, und
bei Betrachtung der Elektrodenbefestigungsflächen des ersten und dritten Dual-Element-Leistungsmoduls (1a, 1c) von einer Rückseite der Elektrodenbefestigungsfläche des zweiten Dual-Element-Leistungsmoduls (1b) in perspektivischer Draufsicht,
eine erste Elektrode (M11) und eine dritte Elektrode (M13) im ersten Dual-Element-Leistungsmodul (1a), eine erste Elektrode (M31) und eine dritte Elektrode (M33) im dritten Dual-Element-Leistungsmodul (1c) und eine zweite Elektrode (M22) im zweiten Dual-Element-Leistungsmodul (1b) in einer Richtung orthogonal zur Mittelebene ausgerichtet sind, und eine zweite Elektrode (M12) im ersten Dual-Element-Leistungsmodul (1a), eine zweite Elektrode (M32) im dritten Dual-Element-Leistungsmodul (1c) und eine erste Elektrode (M21) und eine dritte Elektrode (M23) im zweiten Dual-Element-Leistungsmodul (1b) in einer Richtung orthogonal zur Mittelebene (W) ausgerichtet sind.

5. Dreiphasen-Leistungswandler nach einem der Ansprüche 1 bis 4, wobei Elemente, die die ersten bis dritten Dual-Element-Leistungsmodule (1a, 1b, 1c) bilden, aus einem WideBandgap-Halbleiter gebildet sind.

6. Dreiphasen-Leistungswandler nach Anspruch 5, wobei der WideBandgap - Halbleiter ein Halbleiter aus Siliziumkarbid, einem Material auf Galliumnitridbasis oder Diamant ist.

## Revendications

1. Convertisseur de puissance à trois niveaux comprenant une unité formant circuit de conversion de puissance pour une phase, qui est agencé pour sélectionner l'un quelconque des potentiels d'une borne à courant continu (P) du côté à haut potentiel, d'une borne à courant continu (C) à potentiel intermédiaire, et d'une borne à courant continu (N) du côté à faible potentiel, et pour délivrer le potentiel à une borne à courant alternatif (AC), dans lequel l'unité formant circuit de conversion de puissance inclut un premier module de puissance à double élément (1a) qui inclut un élément de commutation extérieur (10a) sur le côté à haut potentiel du convertisseur de puissance à trois niveaux, et un élément formant pince (12a) sur le côté à haut potentiel du convertisseur de puissance à trois niveaux, un second module de puissance à double élément (1b) qui inclut un élément de commutation intérieur (10b) sur le côté à haut potentiel du convertisseur de puissance à trois niveaux et un élément de commutation intérieur (12b) sur le côté à faible potentiel du convertisseur de puissance à trois niveaux, et un troisième module de puissance à double élément (1c) qui inclut un élément de commutation extérieur (12c) sur le côté à faible potentiel du convertisseur de puissance à trois niveaux et un élément formant pince (10c) sur le côté à faible potentiel du convertisseur de puissance à trois niveaux,
dans lequel le premier, le second et le troisième module de puissance à double élément (1a, 1b, 1c) sont des modules de puissance à triple bornes et à double élément avec la même configuration, dont chacun inclut une première électrode (M11, M21, M31) qui est connectée à une portion du côté à haut potentiel de l'un des éléments de commutation (10a, 10b, 10c), une seconde électrode (M12, M22, M32) qui est connectée à une portion de connexion entre une portion du côté à faible potentiel de l'un des éléments de commutation (10a, 10b, 10c) et une portion du côté à haut potentiel de l'autre élément de commutation (12a, 12b, 12c), et une troisième électrode (M13, M23, M33) qui est connectée à une portion du côté à faible potentiel de l'autre élément (12a, 12b, 12c), et
la première électrode (M11) dans le premier module de puissance à double élément (1a) est connectée à la borne à courant continu du côté à haut potentiel (P), la seconde électrode (M12) dans le premier module de puissance à double élément (1a) et la première électrode (M21) dans le second module de puissance à double élément (1b) sont connectées l'une à l'autre, la troisième électrode (M13) dans le premier module de puissance à double élément (1a) est connectée à la borne à potentiel intermédiaire (C), la première électrode (M31) dans le troisième module de puissance à double élément (1c) est connectée à la borne à potentiel intermédiaire (C), la seconde électrode (M22) dans le second module de puissance à double élément (1b) est connectée à la borne à courant alternatif (AC), la troisième électrode (M23) dans le second module de puissance à double élément (1b) et la seconde électrode (M32) dans le troisième module de puissance à double élément (1c) sont connectées l'une à l'autre, et la troisième électrode (M33) dans le troisième module de puissance à double élément (1c) est connectée à la borne à courant continu du côté à faible potentiel (N) ;
dans lequel
la première, la seconde et la troisième électrode (M11, M12, M13, M21, M22, M23, M31, M32, M33) dans le premier, le second et le troisième module de puissance à double élément (1a, 1b, 1c) sont prévues sur une surface de montage d'électrode sur l'un des côtés de surface principale d'un boîtier de module, et
la première électrode (M11, M21, M31) et la troisième électrode (M13, M23, M33) sont disposées en rangée dans une direction orthogonale à une direction longitudinale du boîtier de module sur l'un des côtés d'extrémité dans la direction longitudinale, et la seconde électrode (M12, M22, M32) est agencée sur l'autre côté d'extrémité dans la direction longitudinale du boîtier de module,
dans lequel
le premier et le troisième module de puissance à double élément (1a, 1c) sont agencés sur un plan de telle façon que les surfaces du côté longitudinal de leurs boîtiers de module respectifs sont adjacentes l'une à l'autre, et que des surfaces de montage d'électrodes des boîtiers de module sont dirigées dans la même direction, et le second module de puissance à double élément (1b) est agencé de telle façon qu'une ligne centrale d'un boîtier de module dans une direction longitudinale s'étend parallèlement à un plan central (W),
le plan central (W) étant orthogonal audit plan et croisant ledit plan entre les centres du premier module de puissance à double élément (1a) et du troisième module de puissance à double élément (1c), et
dans lequel le second module de puissance à double élément (1b) est agencé de telle façon que la seconde électrode (M22) est positionnée sur le croisement dudit plan avec le plan central, et
dans lequel
le second module de puissance à double élément (1b), la première électrode (M21) et la troisième électrode (M23) sont agencés symétriquement par rapport au plan central (W).

2. Convertisseur de puissance à trois niveaux selon la revendication 1, dans lequel la seconde électrode (M12) dans le premier module de puissance à double élément (1a) et la seconde électrode (M32) dans le troisième module de puissance à double élément (1c) sont agencées de manière à être alignées dans une direction orthogonale au plan central (W).

3. Convertisseur de puissance à trois niveaux selon l'une quelconque des revendications 1 et 2, dans lequel le second module de puissance à double élément (1b) est agencé de telle façon qu'une surface latérale d'un boîtier de module du second module de puissance à double élément (1b), sur un côté où la première et la troisième électrode (M21, M23) sont prévues, est adjacente à des surfaces latérales de boîtier de module du premier et du troisième module de puissance à double élément (1a, 1c) sur un côté où la seconde électrode (M12, M32) est prévue.

4. Convertisseur de puissance à trois niveaux selon l'une quelconque des revendications 1 et 2,
dans lequel une surface de montage d'électrode du second module de puissance à double élément (1b) est agencée de manière à être opposée à des surfaces de montage d'électrodes du premier et du troisième module de puissance à double élément (1a, 1c), et
quand les surfaces de montage d'électrodes du premier et du troisième module de puissance à double élément (1a, 1c) sont vues depuis un côté arrière de la surface de montage d'électrode du second module de puissance à double élément (1b) dans une vue en plan en perspective, une première électrode (M11) et une troisième électrode (M13) dans le premier module de puissance à double élément (1a), une première électrode (M31) et une troisième électrode (M33) dans le troisième module de puissance à double élément (1c), et une seconde électrode (M22) dans le second module de puissance à double élément (1b) sont alignées dans une direction orthogonale au plan central, et une seconde électrode (M12) dans le premier module de puissance à double élément (1a), une seconde électrode (M32) dans le troisième module de puissance à double élément (1c), et une première électrode (M21) et une troisième électrode (M23) dans le second module de puissance à double élément (1b) sont alignées dans une direction orthogonale au plan central (W).

5. Convertisseur de puissance à trois niveaux selon l'une quelconque des revendications 1 à 4, dans lequel des éléments qui constituent le premier, le second et le troisième module de puissance à double élément (1a, 1b, 1c) sont formées avec un semi-conducteur à grande largeur de bande.

6. Convertisseur de puissance à trois niveaux selon la revendication 5, dans lequel le semi-conducteur à grande largeur de bande est un semi-conducteur réalisé en carbure de silicium, en un matériau à base de nitrure de gallium, ou en diamant.
